**Europäisches Patentamt**

**European Patent Office**

**Office européen des brevets**

(19)

(11) Veröffentlichungsnummer: **0 107 040**
**B1**

(12) # EUROPÄISCHE PATENTSCHRIFT

(45) Veröffentlichungstag der Patentschrift:
11.06.86

(51) Int. Cl.⁴: **G 01 R 31/28**

(21) Anmeldenummer: 83109341.4

(22) Anmeldetag: 20.09.83

(54) **Verfahren und Vorrichtung zur Aufzeichnung von Signalverläufen an einer zyklisch betriebenen Probe in Abhängigkeit von einem sporadisch aufgetretenen Ereignis.**

(30) Priorität: 27.09.82 DE 3235700

(43) Veröffentlichungstag der Anmeldung:
02.05.84 Patentblatt 84/18

(45) Bekanntmachung des Hinweises auf die Patenterteilung:
11.06.86 Patentblatt 86/24

(84) Benannte Vertragsstaaten:
**DE GB NL**

(56) Entgegenhaltungen:
**EP - A - 0 048 858**
**DE - A - 3 040 733**
**GB - A - 2 014 014**

(73) Patentinhaber: **Siemens Aktiengesellschaft, Berlin und München Wittelsbacherplatz 2, D-8000 München 2 (DE)**

(72) Erfinder: **Fazekas, Peter, Dipl.-Ing., Stuntzstrasse 21, D-8000 München 80 (DE)**

LIBER, STOCKHOLM 1986

EP 0 107 040 B1

## Beschreibung

Die Erfindung betrifft ein Verfahren zur Aufzeichnung von Signalverläufen an einer zyklisch betriebenen Probe nach dem Oberbegriff des Anspruchs 1 und eine entsprechende Vorrichtung.

Die Messung hochfrequenter Signalverläufe ist in der Elektronenstrahl-Meßtechnik mit einem Sampling-Verfahren möglich (H.P. Feuerbaun et al, "Signal Processing for E-Beam Waveform Measurements", Proc. of Microcircuit Engineering 87 (1981), 507-513). Bei diesem bekannten Verfahren zur Messung hochfrequenter Signalverläufe wird wegen des verrauschten Signals an jedem Phasenpunkt der periodischen Signalverläufe über mehrere Abtastwerte hinweg gemittelt. Werden nun hochfrequente Signalverläufe innehalb einer integrierten Schaltung gemessen und treten dabei sporadische Ereignisse, z.B. sporadische Fehler, auf, die sich nur in einem Teil dar Zyklen eines hochfrequentan Signalverlaufs zeigen, so wird eine Messung hochfrequenter Signalverläufe, die nach diesem bekannten Verfahren durchgeführt wird, verfälscht. Der bei diesem bekannten Verfahren zur Messung hochfrequenter Signalverläufe ermittelte Signalhub kann, solange sporadische Fehler nicht ausgeschlossen werden können, ein Mittelwert aus fehlerfreien und fehlerhaften Abtastwerten sein.

Sporadisch auftretende Ereignisse, das sind unregelmäßig auftretende Signale innerhalb einer Probe bei gleicher Phase des periodischen Signals einer Proben-Ansteuerung, konnten im Innern integrierter Schaltungen bisher nur mit mechanischen Spitzen unter Verwendung von Transienten-Recordern gemessen werden.

Der vorliegenden Erfindung liegt die Aufgabe zugrunde, ein Verfahren und eine Vorrichtung der eingangs genannten Artanzugeben, mit denen auch bei Sehr hochintegrierten Schaltungen sporadisch auftretende Signale aufgezeichnet werden können.

Diese Aufgabe wird erfindungsgemäß durch ein Verfahren nach dem Anspruch 1 und durch eine Vorrichtung nach dem Anspruch 3 gelöst. Ausgestaltungen und Vorteile der Erfindung sind in den Unteranspruchen, der Beschreibung und der Zeichnung dargestellt.

Ausführungsbeispiele der Erfindung werden in folgenden anhand der Zeichnung erläutert.

Fig.1 zeigt ein Blockschaltbild einer erfindungsgemäßen Vorrichtung.

Fig.2 zeigt ein Zeitdiagramm für die Durchführung eines erfindungsgemäßen Verfahrens.

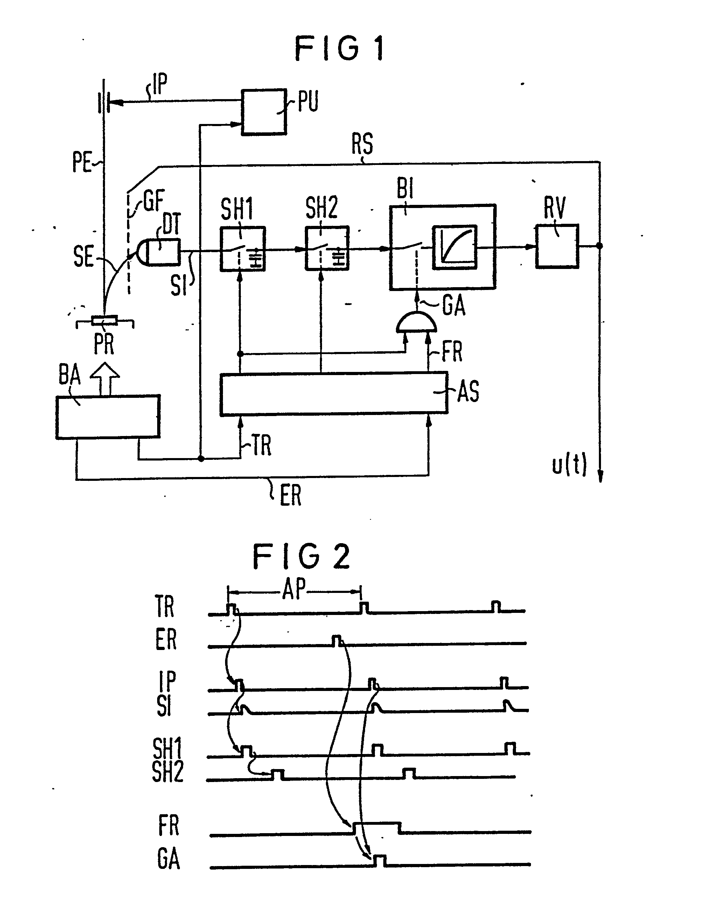

Fig.1 zeigt ein Blockschaltbild einer erfindungsgemäßen Vorrichtung. Die Proben-Ansteuerung BA löst in der Probe PR, beispielsweise einer integrierten Schaltung, hochfrequente Signalverläufe aus. Gleichzeitig wird von der zyklisch arbeitenden Proben-Ansteuerung BA ein Triggersignal TR abgegeben, welches über einen Pulsgenerator PU einen Eintastpuls IP erzeugt. Mit diesem Eintastpuls IP wird ein Puls der Korpuskularsonde PE ausgelöst, welcher seinerseits auf der Probe PR Sekundärelektronen SE auslöst. Ein Teil dieser Sekundärelektronen SE kann ein über eine Gegenfeld-Elektrode GF gesteuertes Gegenfeld überwinden und wird in einem Detektor DT nachgewiesen. Dieser Detektor DT gibt ein entsprechendes Sekundärelektronen-Signal SI weiter. Das Triggersignal TR der Proben-Ansteuerung BA veranlaßt über eine Ablaufsteuerung AS eine erste Sample- and Hold-Schaltung SH1, vom Detektor DT das Sekundärelektronen-Signal SI zu übernehmen. Kurz darauf veranlaßt die Ablaufsteuerung AS von sich aus eine zweite Sample- and Hold-Schaltung SH2, von der ersten Sample- and Hold-Schaltung SH7 das Sekundärelektronen-Signal SI weiter zu übernehmen. Gibt nun die Proben-Ansteuerung BA vor Ende des betreffenden Zyklus das periodischen Signals, mit dem die Probe PT angesteuert wird, durch ein Ereignis-Signal ER bekannt, daß ein sporadisches Ereignis, z.B. ein Fehler, aufgetreten ist, dann wird über eine Leitung für das Ereignis-Signal ER die Ablaufsteuerung AS veranlaßt, ein Freigabe-Signal FR für die Signalverarbeitung abzugeben. Wenn sowohl die Leitung für das Freigabe-Signal FR als auch diejenige Leitung, die die erste Sample- and Hold-Schaltung SH1 veranlaßt, ein Sekundärelektronen-Signal SI zu übernehmen, aktiviert sind, wird in demjenigen Zyklus, der auf den betreffenden Zyklus der Proben-Ansteuerung folgt, der Gate-Eingang GA eines Boxcar-Integretors BI geöffnet und damit die Übernahme des Inhalts der zweiten Sample- and Hold-Schaltung SH2 in den Boxcar-Integrator BI verranlaßt.

Gleichzeitig mit dieser Übernahme des Sekundärelektronen-Signals SI aus dem betroffenen Zyklus, in dem ein sporadisches Ereignis aufgetreten ist, wird ein Sekundärelektronen-Signal SI in die erste Sample- and Hold-Schaltung SH1 eingeschrieben, welches aus demjenigen Zyklus der Proben-Ansteuerung stammt, welcher unmittelbar auf den betreffenden Zyklus, in dem des sporadische Ereignis aufgetreten war, folgt.

Tritt in einem Zyklus ein sporadisches Ereignis nicht ein, dann erfolgt keine Weitergabe des als diesem Zyklus her stammenden Inhalts der zweiten Sample- and Hold-Schaltung SH2 an die Signalverarbeitung.

Über einen Regelverstärker RV kann eine Rückkopplungsschleife RS für eine quantitative Potentialmessung geschlossen werden. Der Ausgang des Boxcar-Intergrators ist dann an den Eingang des Regelverstärkers RV angeschlossen. Der Ausgang des Regelverstärkers RV ist seinerseits an die Gegenfeld-Elektrode GF innerhalb eines Sekundärelektronen-Spektrometers angeschlossen. Der Arbeitspunkt der Rückkopplungsschleife RS kann nun so gesteuert werden, daß der Ausgang des Regelverstärkers RV als quantitatives Meßsignal für den Spannungs-wert an einem Meßpunkt an der Probe PR benutzt werden, der zu einer bestimmten Phase innerhalb eines Zyklus der zyklischen Proben-Ansteuerung beim Auftreten eines sporadischen Ereignisses angelegt war.

Als Boxcar-Integrator BI kann ein PAT Model 162 bzw. 165 verwendet werden. Für den Grundaufbau einer Vorrichtung nach Fig.1 können Geräte verwendet werden, wie Sie in der Veröffentlichung von H.P. Feuerbaum, Scanning Electron Microscopy/1979/I, 285-296 beschrieben sind. Nach Auslösen eines Eintastpulses IP über ein Triggersignal TR ist des Eintreffen des zugehörigen Sekundärelektronen-Signals SI am Eingang der ersten Sample- and Hold-Schaltung SHI mit einer Verzögerung von etwa 250 ns zu erwerten. Diese Verzögerung ist bei dem Übernahmebefehl durch die Ablaufsteuerung AS an diese erste Sample- and Hold-Schaltung SHI zur Übernahme des zugehörigen Sekundärelektronen-Signals SI zu beachten.

Fig.2 zeigt ein Zeitdiagramm zur Durchführung eines erfindungsgemäßen Verfahrens. In jeder Periode der zyklischen Ansteuerung der Probe PR durch die Proben-Ansteuerung BA wird ein Triggersignal TR ausgelöst. Werden zwei aufeinanderfolgende Triggersignale TR bei derselben Phase einer periodischen Ansteuerung ausgelöst, so entspricht ihr zeitlicher Abstand einer Abtastperiode AP. Das Auslösen eines Trägersignals TR veranlaßt des Auslösen eines Eintastpulses IP. Der damit ausgelöste Puls einer Korpuskularsonde PE löst auf der Probe PR Sekundärelektronen SE aus, die ihrerseits im Detektor DT ein Sekundärelektronen Signal SI hervorrufen. Bei Erscheinen des Sekundärelektronen-Signals SI am Ausgang des Detektors DT erhält die erste Sample- and Hold-Schaltung SH1 den Befehl zur Übernahme des Sekundärelektronen-Signals SI. Kurz darauf wird die Übernahmeleitung der zweiten Sampleand Hold-Schaltung SH2 aktiviert. Wird nun am Ende des ersten Zyklus von der Proben-Ansteuerung BA ein eingetretenes sporadisches Ereignis gemeidet, so wird die Freigabeleitung FR aktiviert. Ist nun über ein neues Triggersignal TR während eines zweiten Zyklus der Proben-Ansteuerung die Übernahmeleitung an die erste Sample- and Hold-Schaltung SH7 für die Übernahme des aus diesem zweiten Zyklus stammenden Sekundärelektronen-Signals SI aktiviert, so wird über eine logische Verknüpfung dieses zuletzt genannten Übernahmebefehls, welches aus dem zweiten Zyklus stammt, und dem Freigabesignal FR, welches aus dem ersten Zyklus stammt, der Gate-Eingang GA des Boxcar-Integrators BI geöffnet. Erst während des zweiten Zyklus der Proben-Ansteuerung wird also das Sekundärelektronen-Signals SI, welches aus dem ersten Zyklus stammt, wobei während dieses ersten Zyklus ein sporadisches Ereignis eingetreten ist, vom Boxcar-Integrator BI übernommen. Kurz nach Übergabe des Sekundärelektronen-Signals aus dem ersten Zyklus an den Boxcar-Integrator BI übernimmt die zweite Sample- and Hold-Schaltung SH2 daa Sekundärelektronen-Signal SI aus dem zweiten Zyklus von der ersten Sample- and Hold-Schaltung SH1.

Die Sample- and Hold-Schaltungen SH1, SH2 können als Track- and Hold-Schaltungen ausgeführt werden.

**Patentansprüche**

1. Verfahren zur Aufzeichnung von Signalverläufen an einer zyklisch betriebenen Probe (PR), bei dem von einer Korpuskularsonde (PE) auf der Probe (PR) Sekundärelektronen (SE) ausgelöst werden, die in einem Detektor (DT) ein Sekundärelektronen-Signal (SI) hervorrufen, bei dem eine Proben-Ansteuerung (BA) die Probe (PR) ansteuert und bei dem das Sekundärelektronen-Signal (SI) aufgezeichnet wird, dadurch gekennzeichnet, daß das Sekundärelektronen-Signal (SI) zunächst zwischengespeichert wird und nur dann aufgezeichnet wird, wenn ein sporadisches Ereignis auf der Probe (PR) eingetreten ist.

2. Verfahren nach Anspruch 1, dadurch gekennzeichnet, daß das Sekundärelektronen-Signal (SI) in einer Sample- and Hold-Schaltung (SH1) zwischengespeichert wird, daß dieses Sekundärelektronen-Signal (SI) an eine zweite Sample- and Hold-Schaltung (SH2) weitergegeben wird, und daß nur dann, wenn von der Proben-Ansteuerung (BA) ein sporadisches Ereignis (ER) gemeldet wird, dieses Sekundärelektonen-Signal (SI) aufgezeichnet wird.

3. Vorrichtung zur Aufzeichnung von Signalverläufen an einer zyklisch betriebenen Probe (PR), mit einer Korpuskularsonde (PE) zur Auslösung von Sekundärelektronen (SE) auf der Probe (PR), mit einem Detektor (DT) zum Erfassen eines Sekundärelektronen Signals (SI), mit einer Baustein-Ansteuerung (BA) zur Ansteuerung der Probe (PR), mit einer Vorrichtung (BI, RV) zur Aufzeichnung des Sekundärelektronen-Signals (SI), gekennzeichnet durch einen Ausgang (TR) der Baustein-Ansteuerung (BA) zur Festlegung einer Zwischenspeicherung eines Sekundärelektronen-Signals (SI) und einen weiteren Ausgang (ER) der Baustein-Ansteuerung (BA) zur Meldung eines sporadischen Ereignisses.

4. Vorrichtung nach Anspruch 3, dadurch gekennzeichnet, daß der Ausgang (TR) der Baustein-Ansteuerung (BA) zur Festlegung einer Zwischenspeicherung eines Sekundärelektronen-Signals(SI) mit einer Sample- and Hold-Schaltung (SHI) verknüpft ist.

6. Vorrichtung nach einem der Ansprüche 3 bis 5, dadurch gekennzeichnet, daß zwischen Detektor (DT) und der Vorrichtung (BI, RV) zur Aufzeichnung des Sekundärelektronen-Signals (SI) zwei Sample- and Hold-Schaltungen (SHI, SH2) zur Speicherung des Sekundärelektronen-Signals (SI) geschaltet sind.

7. Vorrichtung nach einem der Ansprüche 3 bis 6, dadurch gekennzeichnet, daß eine Ablaufsteuerung (AS) zwischen Proben-Ansteuerung (BA) und den Mitteln (SH1, SH2, BI, RV) zur Zwischenspeicherung und zur Aufzeichnung des Sekundärelektronen-Signals (SI) angeordnet ist. 5. Vorrichtung nach Anspruch 3 oder 4, dadurch gekennzeichnet, daß der Ausgang (ER) der Baustein-Ansteuerung (BA) zur Meldung eines sporadischen Ereignisses über eine Ablaufsteuerung (AS) mit einem Gate-Eingang (GA) eines Boxcar-Integrators (BI) verknüpft ist.

## Claims

1. A method for recording signal variations from a cyclically operated probe (PR), wherein secondary electrons (SE) which cause a secondary electron signal (SI) in a detector (DT), are triggered by a corpuscular sampling device (PE) on the probe (PR), wherein a probe control unit (BA) controls the probe (PR) and wherein the secondary electron signal (SI) is recorded, characterised in that the secondary electron signal (SI) is firstly intermediately stored and only recorded if a sporadic event has occurred on the probe (PR).

2. A method as claimed in claim 1, characterised in that the secondary electron signal (SI) is intermediately stored in a sample and hold circuit (SH1), that the secondary electron signal (SI) is transmitted to a second sample and hold circuit (SH2), and that the secondary electron signal (SI) is only recorded if a sporädic event (ER) is indicated by the probe control unit (BA).

3. A device for recording signal variations from a cyclically operated probe (PR), having a corpuscular sampling device (PE) for triggering secondary electrons (SE) on the probe (PR), having a detector (DT) for detecting a secondary electron signal (SI), having a module control unit (BA) for controlling the probe (PR), having a device (BI,RV) for recording the secondary electron signal (SI), characterised by an output (TR) of the module control unit (BA) for determining an intermediate storage of a secondary electron signal (SI) and a further output (ER) of the module control unit (BA) for indicating a sporadic event.

4. A device as claimed in claim 3, characterised in that the output (TR) of the module control unit (BA) is coupled to a sample and hold circuit (SHI) in order to determine an intermediate storage of a secondary electron signal (SI).

5. A device as claimed in claim 3 or 4, characterised in that the output (ER) of the module control unit (BA) is coupled to a gate input (GA) of a boxcar integrator (BI) by means of a sequence control unit (AS) in order to signal a sporadic event.

6. A device as claimed in one of the claims 3 to 5, characterised in that two sample and hold circuits (SH1, SH2) for storing the secondary electron signal (SI) are inserted between detector (DT) and the device (BI, RV) for recording the secondary electron signal (SI).

7. A device as claimed in one of claims 3 to 6, characterised in that a sequence control unit (AS) is arranged between the probe control unit (BA) and the means (SH1, SH2, BI, RV) for the intermediate storage and for recording the secondary electron signal (SI).

## Revendications

1. Procédé pour enregistrer des allures de signaux dans un échantillon (PR) fonctionnant de façon cyclique, selon lequel une sonde corpusculaire (PE) déclenche, sur l'échantillon (PR), l'émission d'électrons secondaires (SE) qui provoquent dans un détecteur (DT) l'apparition d'un signal (SI) produit par les électrons secondaires et selon lequel un dispositif (BA) de commande de l'échantillon commande l'échantillon (PR) et selon lequel le signal (FI) produit par les électrons secondaires est enregistré, caractérisé par le fait que le signal (SI) produit par les électrons secondaires est tout d'abord mémorisé temporairement, et n'est alors enregistré que lorsqu'un phénomène sporadique est apparu sur l'échantillon (PR).

2. Procédé suivant la revendication 1, caractérisé par le fait que le signal (SI) produit par les électrons secondaires est mémorisé temporairement dans un circuit d'échantillonnage et de maintien (SH1), que ce signal (SI) produit par les électrons secondaires est envoyé à un second circuit d'échantillonnage et de maintien (SH2) et que ce signal (SI) produit par les électrons secondaires n'est enregistré que lorsque le dispositif (BA) de commande de l'échantillon signale un phénomène sporadique (ER).

3. Dispositif pour enregistrer des variations de signaux au niveau d'un échantillon (PR) fonctionnant de façon cyclique, comportant une sonde corpusculaire (PE) servant à déclencher l'émission d'électrons secondaires (SE) au niveau de l'échantillon (PR), un détecteur (DT) servant à détecter un signal (SI) produit par les électrons secondaires, un dispositif (BA) de commande du module servant à commander l'échantillon (PR), et un dispositif (BI, RV) servant à enregistrer le signal (SI) produit par les électrons secondaires, caractérisé par une sortie (TR) du dispositif (BA) de commande du module pour la dètermination d'une mémorisation temporaire d'un signal (SI) produit par les électrons secondaires, et par une autre sortie (ER) du dispositif (BA) de commande du module pour la signalisation d'un phénomène sporadique.

4. Dispositif suivant la revendication 3, caractérisé par le fait que pour la détermination d'une mémorisation temporaire d'un signal (SI) produit par les électrons secondaires, la sortie (TR) du dispositif (BA) de commande du module est combinée à un circuit d'échantillonnage et de maintien (SH1).

6. Dispositif suivant l'une des revendications 3 à 5, caractérisé par le fait que deux circuits d'échantillonnage et de maintien (SHI, SH2) servant à mémoriser le signal (SI) produit par les électrons secondaires sont branchés entre un détecteur (DT) et le dispsitif (BI, RV) prévu pour l'enregistrement du signal (SI) produit par les électrons secondaires.

7. Dispositif suivant l'une des revendications 3 à 6, caractérisé par le fait qu'un dispositif (AS) de commande d'exécution est disposé entre le dispositif (BA) de commande de l'échantillon et les moyens (SHI, SH2, BI, RV) pour la mémorisation temporaire et pour l'enregistrement du signal (SI) produit par les électrons secondaires.

5. Dispositif suivant la revendication 3 ou 4, caractérisé par le fait que pour la signalisation d'un phénomène sporadique, la sortie (ER) du dispositif (BA) de commande du module est combinée par l'intermédiaire d'un dispositif (AS) de commande d'exécution à une entrée de porte (GA) d'un intégrateur Boxcar (BI).

# FIG 1

# FIG 2